# EUROPÄISCHE PATENTSCHRIFT

(11) **EP 3 891 886 B1**
(45) Veröffentlichungstag und Bekanntmachung des Hinweises auf die Patenterteilung: **27.12.2023**
(21) Anmeldenummer: 19808709.0
(22) Anmeldetag: 12.11.2019
(51) Int. Cl.: H03F 1/02, H01L 23/66, H03F 1/56, H03F 3/195

(54) **HOCHFREQUENZ-LEISTUNGSTRANSISTOR UND HOCHFREQUENZ-LEISTUNGSVERSTÄRKER**
HIGH-FREQUENCY POWER TRANSISTOR AND HIGH-FREQUENCY POWER AMPLIFIER
TRANSISTOR DE PUISSANCE HAUTE FRÉQUENCE ET AMPLIFICATEUR DE PUISSANCE HAUTE FRÉQUENCE

(30) Priorität: 05.12.2018 DE 102018131040
(43) Veröffentlichungstag der Anmeldung: 13.10.2021
(73) Patentinhaber: Ferdinand-Braun-Institut gGmbH, Leibniz-Institut für Höchstfrequenztechnik, 12489 Berlin (DE)
(72) Erfinder: BENGTSSON, Olof, 12555 Berlin (DE); PAUL, Sophie, 12439 Berlin (DE); KUREMYR, Tobias, 75431 Uppsala (SE)
(74) Vertreter: Gulde & Partner
(86) Internationale Anmeldenummer: PCT/EP2019/081064
(87) Internationale Veröffentlichungsnummer: WO 2020/114731

(56) Entgegenhaltungen:
- WO-A1-99/40629
- WO-A1-99/40629
- JP-A- S53 132 249
- US-A1- 2011 221 519
- US-B1- 6 593 797
- US-B1- 6 593 797

## Beschreibung

Die Erfindung betrifft einen Hochfrequenz-Leistungstransistor und im Speziellen betrifft die Erfindung die Trennung von Hochfrequenz- und Gleichstrom- bzw. Niederfrequenz-Masse innerhalb des Leistungstransistorgehäuses. Der Betrieb eines Hochfrequenz- (HF) Leistungstransistors mit potentialfreier Masse wird durch Einfügen eines HF-Bypasskondensators in das Transistorgehäuse ermöglicht. Durch den Kondensator wird eine Trennung der HF-Masse von der DC- (engl. direct current, dt. Gleichstrom) und Niederfrequenz- (NF) Masse erzeugt. Indem der HF-Bypasskondensator im Gehäuse und so nah wie möglich am Transistor platziert wird, kann die Induktivität des HF-Pfades zwischen dem Sourcekontakt des Transistors und der Systemmasse reduziert werden. Dadurch werden die Effizienz, die DC- & NF- / HF-Isolation und somit auch die NF-Bandbreite sowie die Stabilität verbessert. Ein separater DC- & NF-Anschluss am Gehäuse ermöglicht den potentialfreien Betrieb bei einer großen NF-Bandbreite (engl. video bandwidth), wobei die erreichbare Bandbreite von etwa 10 MHz auf mehrere hundert MHz erhöht wird.

### Technologischer Hintergrund der Erfindung

HF-Leistungsverstärker sind bekanntlich Schlüsselkomponenten in drahtlosen Kommunikationssystemen. Sie verstärken HF-Signale auf Leistungsniveaus, die für die Übertragung über eine bestimmte Entfernung erforderlich sind. Um die Datenübertragung mit hohen Datenraten oder großer Bandbreite zu ermöglichen, werden komplexe Modulationsschemata auf das HF-Signal angewendet, die zu einer variierenden Signalleistung führen.

In Anbetracht der Tatsache, dass Energieverbrauch und Energieeinsparung kritische Aspekte bei HF-Leistungsverstärkern sind, ist es wichtig, HF-Leistungsverstärker in einem energieeffizienten Modus zu betreiben. Bei linearen HF-Leistungsverstärkern ist der Wirkungsgrad im Bereich der maximalen Ausgangsleistung am höchsten und nimmt mit reduzierter Ausgangsleistung, d.h. bei Power Backoff, ab.

Ein Ansatz zur Erhöhung der HF-Leistungsverstärker-Effizienz bei Power Backoff ist das Hüllkurvenverfolgungs-Verfahren (englisch: envelope tracking technique, ET-technique), bei dem die Versorgungsspannung des HF-Leistungsverstärkers entsprechend der momentanen Leistung des modulierten HF-Signals angepasst wird. Das ET-Verfahren reduziert somit die Leistungsaufnahme und damit die Verlustleistung eines HF-Leistungsverstärkers.

Die extreme Bandbreite moderner Kommunikationssignale erfordert einen sehr schnellen Hüllkurvenverstärker, d.h. ein Gleichspannungswandler kann den HF-Leistungsverstärker mit einer Spannung versorgen, die der momentanen Leistungsänderung im HF-Signal entspricht. Alle solchen schnellen Gleichspannungswandler beinhalten eine Art Schaltstufe.

In der einfachsten Form kann der Gleichspannungswandler ein Abwärtswandler sein, der die Last speist, was für ein ET-System, das ein ET-Verfahren verwendet, der HF-Leistungsverstärker ist. In dieser Topologie ist der HF-Leistungsverstärker mit der Masse verbunden, was bedeutet, dass der Abwärtswandler in Richtung der ET-System-Versorgungsspannung arbeitet, wobei der HF-Leistungsverstärker vom potentialfreien Abwärtswandler-Ausgang versorgt wird. Dazu ist entweder ein p-Kanal Feldeffekttransistor oder ein n-Kanal Feldeffekttransistor mit isoliertem Schalttreiber erforderlich.

Neuartige ultraschnelle Verbindungshalbleiter eignen sich aufgrund ihrer geringen parasitären Kapazitäten sehr gut für Schaltanwendungen, aber nur n-Typ-Material ist mit hoher Leistung und Schaltgeschwindigkeit verfügbar. Eine vielversprechende Topologie in Bezug auf Schaltfrequenz und Belastbarkeit ist ein Abwärtswandler mit einem solchen n-Kanal-Feldeffekttransistor. Der vorgenannte isolierte Gate-Schalter ist jedoch kompliziert zu implementieren und führt zu einer parasitären Kapazität, die das Schaltverhalten beeinflusst und einen großen Einfluss auf die gesamten ET-Systemeigenschaften hat.

Um dies zu verhindern, wird in WO 2014/170710 A1 ein Hüllkurvenverfolgungssystem mit einem umgekehrten Abwärtswandler vorgeschlagen. Die vorgeschlagene Topologie ist ungewöhnlich in dem Sinne, dass die Versorgungsspannung des HF-Leistungsverstärkers modifiziert wird, indem das NF-Source-Potential des HF-Leistungsverstärker-Transistors variiert wird, während Systemmasse und HF-Masse gemeinsam gehalten werden. Der HF-Leistungsverstärker ist somit gegenüber der Gleichspannungs-Einspeisung, oder in diesem Fall dem NF-Source-Potential, potentialfrei. In einem solchen ET-System unter Verwendung eines umgekehrten Abwärtswandlers bildet der HF-Leistungsverstärker die Last des Abwärtswandlers, wird aber aus dem Spannungsabfall zwischen der Versorgungsspannung des ET-Systems und dem Ausgang des Abwärtswandlers mit potentialfreier Masse versorgt. Weitere gewöhnliche Leistungstransistoren sind in US 6,593,797 B1, US 6,734,728 B1, US 2018/0262170 A2, US 5,841,184 A, WO 99/40629 A1 und US 2011/0221519 A1 und JPS53132249A offenbart.

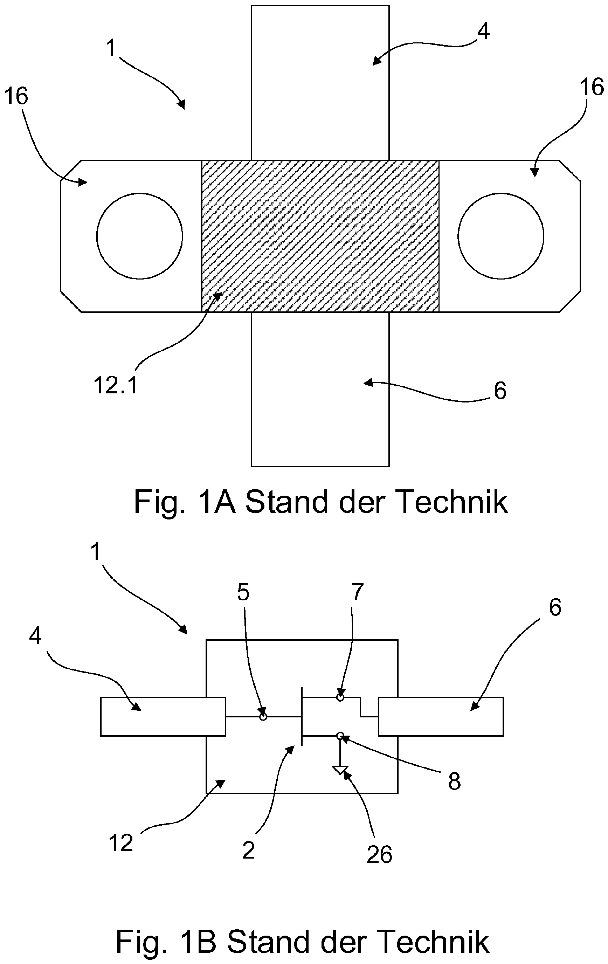

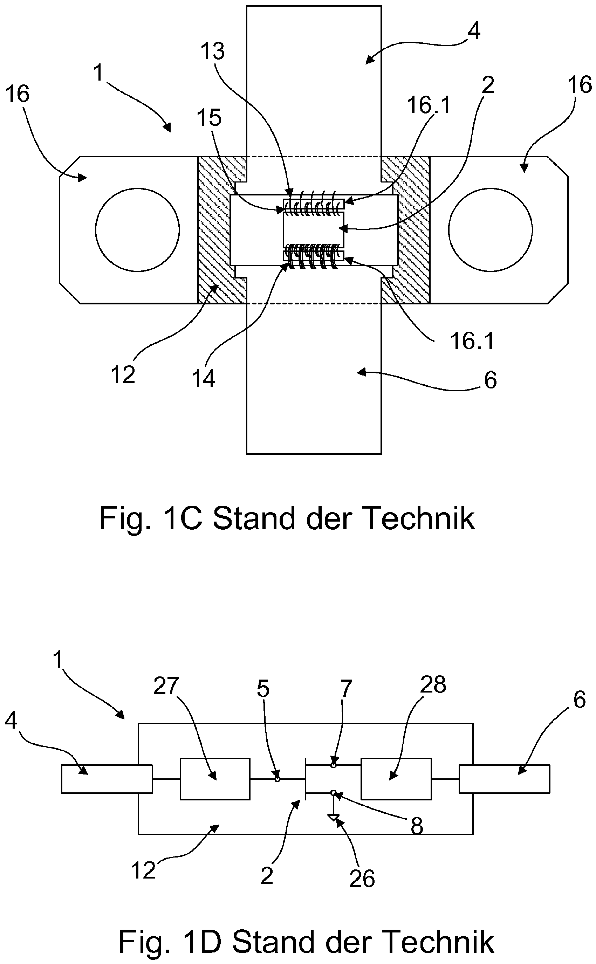

HF-Leistungstransistoren, die 10 W oder mehr Leistung liefern und die Kernelemente solcher Leistungsverstärker darstellen, werden typischerweise, wie in den Figuren 1A, 1B und 1C dargestellt, als separate, in jeweils ein Gehäuse eingebaute elektrische Bauelemente verwendet. Das in Fig. 1A und 1C gezeigte HF-Leistungstransistorgehäuse umfasst einen Flansch mit hoher elektrischer und thermischer Leitfähigkeit, einen darauf angebrachten elektrisch isolierenden Rahmen, der die wiederum darauf angebrachten zwei elektrischen Anschlüsse von dem Flansch isoliert, sowie einen elektrisch isolierenden Deckel, der den Inhalt des Gehäuses schützt. Der im Gehäuse enthaltene Transistor wird (zusammen mit weiteren benötigten Bauelementen) auf dem Flansch innerhalb des elektrisch isolierenden Rahmens platziert. Bei dem in Fig. 1C gezeigten gehäusten Transistor, welcher entweder ein Feldeffekt- (FET) oder Bipolar- (BJT) Transistor sein kann, werden Bonddrähte verwendet um den Eingangsanschluss mit dem Gatekontakt des FETs (oder dem Basiskontakt eines BJTs), den Drainkontakt des FETs (oder Emitterkontakt eines BJTs) mit dem Ausgangsanschluss sowie den Sourcekontakt des FETs (oder Kollektorkontakt eines BJTs) mit der Systemmasse zu verbinden. Da es sich bei dem dargestellten Transistorchip um einen Transistor ohne Vias handelt, werden elektrisch leitfähige Bondstützpunkte nahe am Transistor platziert, die über den Flansch des Leistungstransistorgehäuses direkt mit der Systemmasse verbunden sind. Der gehäuste Transistor aus Fig. 1A, 1B und 1C kann zusätzlich, wie in Abb. 1D gezeigt, ein Eingangsanpassungsnetzwerk, das den Eingangsanschluss mit dem Gatekontakt des FETs (oder dem Basiskontakt eines BJTs) verbindet, und/oder ein Ausgangsanpassungsnetzwerk, das den Drainkontakt des FETs (oder Emitterkontakt eines BJTs) mit dem Ausgangsanschluss verbindet, enthalten.

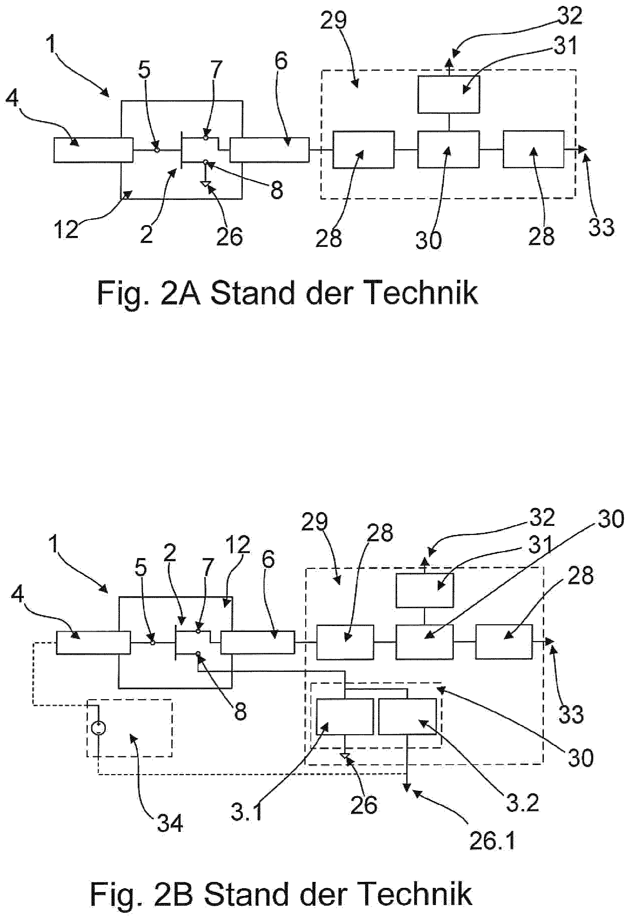

Der gehäuste Transistor wird typischerweise, wie in Fig. 2A gezeigt, in eine Platine eingebaut. Auf dieser Platine befinden sich auch Anpassungsnetzwerke und DC- & NF- / HF-Diplexer, die den Ausgangsanschluss des Transistors mit dem HF-Ausgang verbinden. Eine DC- & NF-Spannungsversorgung ist über eine DC- & NF-Versorgungsleitung mit dem beschriebenen Diplexer und somit mit dem Ausgangsanpassungsnetzwerk und dem Ausgangsanschluss des Transistors verbunden. Diese zweifache Funktion der Schaltung auf der Platine bewirkt die gezielte Impedanzanpassung bei der Trägerfrequenz und stellt zugleich einen Weg für die Zuführung der DC-Versorgungsspannung für den Transistor dar. Außerdem muss die Schaltung die DC- & NF-Versorgung vom HF-Ausgang trennen und ein Einkoppeln des HF-Signals in den Versorgungspfad unterdrücken.

Für den potentialfreien Betrieb des typischen HF-Leistungstransistors muss die HF-Masse von der DC- & NF-Masse außerhalb des Transistorgehäuses getrennt werden. Dies kann, wie in Fig. 2B gezeigt, durch das zusätzliche Einbringen eines DC- & NF- / HF-Diplexers in die Schaltung auf der Platine erreicht werden. Der Masseanschluss des Transistors, sprich der Flansch, wird dann über ein HF-Bypassnetzwerk mit der Systemmasse und über ein DC-& NF-Tiefpassnetzwerk mit dem potentialfreien DC- & NF-Anschluss verbunden. Das Gate des Transistors muss für den potentialfreien Betrieb über eine galvanisch getrennte Spannungsversorgung angesteuert werden.

Der Abstand zwischen dem Transistor und den für die Massetrennung relevanten Schaltungsteilen ist ein Nachteil dieser Realisierungsmöglichkeit, da durch die zusätzlichen Leitungslängen zusätzliche Induktivitäten und elektrische Verzögerungen erzeugt werden. Zusammen mit den Kondensatoren, die für den HF-Bypass auf der Platine benötigt werden, wird somit die NF-Bandbreite begrenzt.

Alternativ kann der potentialfreie Betrieb eines bloßen HF-Leistungstransistors ohne Vias und ohne Gehäuse mit einem Hybridaufbau realisiert werden, bei dem die Massetrennung zwischen HF bzw. DC & NF durch einen unmittelbar neben dem Transistorchip auf dem Flansch platzierten bondbaren Bypasskondensator erzeugt wird, dessen obere Elektrode durch Bonddrähte mit dem Sourcekontakt des Transistors verbunden ist und dessen untere Elektrode direkt mit dem Flansch kontaktiert ist. Weiterhin ist der Sourcekontakt des Transistors durch Bonddrähte mit dem DC- & NF-Tiefpassnetzwerk und der zugehörigen potentialfreien Masse auf der umgebenden Platine verbunden. Die Gate- und Drainkontakte des Transistors sind ebenfalls durch Bonddrähte mit den Eingangs- und Ausgangsnetzwerken auf der umgebenden Platine verbunden, was dem Bonden zu den Ein- und Ausgangsanschlüssen in einem typischen HF-Leistungstransistorgehäuse entspricht.

Problematisch bei den bekannten Lösungen ist das Folgende:
(1) Es gibt keine genau definierte Schnittstelle zwischen dem potentialfreien Transistor und den umgebenden Netzwerken. Dies bedeutet das:
   a. Eine korrekte Charakterisierung der Leistung und Stabilität des potentialfreien Transistors zusammen mit dem bondbaren Kondensator ist nicht möglich.
   b. Es kann für Simulationen kein HF-Modell außer für die einzelnen Zellen des Transistors extrahiert werden.
   c. Die Vorhersagbarkeit des HF-Leistungsverstärker-Verhaltens und damit des gesamten ET-Systems ist nicht gut.
(2) Der mechanische Aufbau einer Schaltung mit bloßem Transistorchip und bondbarem Kondensator ist sehr kompliziert und die aufgebaute Schaltung ist nicht vor mechanischen Beschädigungen geschützt. Dies bedeutet das:
   a. Aus mechanischer Sicht sind einfache und schnelle Konstruktionen nicht möglich.
   b. Der HF-Leistungsverstärker mit gebondetem Transistorchip und Kondensator ist anfällig für mechanische Beschädigungen. Gleichzeitig ist es schwierig, im Falle eines mechanischen oder elektrischen Transistorschadens eine Reparatur durchzuführen und nur wenige Reparaturen sind überhaupt möglich.

### Zusammenfassung der Erfindung

Die Aufgabe besteht darin, einen Hochfrequenz-Leistungstransistor bereitzustellen, der zumindest einen Teil der oben genannten Nachteile überwindet.

Die vorliegende Erfindung bezieht sich auf einen Gegenstand, der in den beigefügten Ansprüchen definiert ist.

Erfindungsgemäß wird ein Hochfrequenz-Leistungstransistor nach dem unabhängigen Anspruch 1 vorgestellt.

Unter NF wird normalerweise Langwellen-Strahlung mit 30 kHz bis 300 kHz verstanden. Hier ist NF als eine generelle Bezeichnung umfassend Strahlung mit der Modulationsfrequenz (MF) oder im Basisband im Frequenzbereich DC (0 Hz) bis mehrere hundert Megahertz, noch bevorzugter bis 400 MHz, zu verstehen. Unter HF wird normalerweise Kurzwellen-Strahlung mit 3 MHz bis 30 MHz verstanden. Hier ist HF als eine generelle Bezeichnung umfassend Strahlung im Bereich 500 MHz bis mehrere GHz zu verstehen, noch bevorzugter bis 5 GHz und noch bevorzugter bis 10 GHz. Die obere NF-Grenze ist von der HF-Trägerfrequenz abhängig und kann mit der vorgeschlagenen Lösung bis zu 20% der HF-Trägerfrequenz erreichen, und kann noch bevorzugter bis zu 40% der HF Trägerfrequenz erreichen. Wird das beschriebene Verhältnis von NF zu HF berücksichtigt, kann bei einer bevorzugten HF von 10 GHz eine NF von vorzugsweise 4 GHz erreicht werden.

Vorzugsweise ist der Widerstand zwischen dem Sourcekontakt des Transistors und dem Kondensator kleiner als 1 Ohm, noch bevorzugter kleiner als 0.5 Ohm und noch bevorzugter kleiner als 10 mOhm.

Vorzugsweise ist die Induktivität zwischen dem Sourcekontakt des Transistors und der Systemmasse kleiner als 0.8 nH, noch bevorzugter kleiner als 0.1 nH und noch bevorzugter kleiner als 10 pH.

Vorzugsweise ist eine potentialfreie Masse eine geräteinterne Masse ohne einen Bezug zur Erde.

Unter galvanischer Trennung (auch galvanische Entkopplung) wird vorzugsweise das Vermeiden der elektrischen Leitung zwischen zwei Stromkreisen, zwischen denen Leistung oder Signale ausgetauscht werden sollen, verstanden. Die elektrische Leitung wird dabei durch elektrisch nicht leitfähige Kopplungsglieder aufgetrennt. Bei galvanischer Trennung sind die elektrischen Potentiale voneinander getrennt und die Stromkreise sind dann untereinander potentialfrei.

Vorzugsweise wird unter Bypassnetzwerk ein oder mehrere Bypass-Kondensatoren verstanden. Ein Bypass-Kondensator wird auch Ableitungskondensator, Kurzschlusskondensator oder Überbrückungskondensator genannt. Allgemein handelt es sich um einen Kondensator, der für bestimmte Signale oder Störsignale eine Umgehungs- oder Ableitungsstrecke schaffen soll.

Bei einem Diplexer ist vorzugsweise eine elektrisch passive Baugruppe im Bereich der Hochfrequenztechnik mit drei Toren gemeint, der dazu dient, eine geführte elektromagnetische Welle in Abhängigkeit von der Frequenz zwischen zwei Toren zu trennen oder in umgekehrter Betriebsrichtung auf ein Tor zusammenzufügen. Der Diplexer stellt eine spezielle Bauform einer Frequenzweiche dar.

Unter Tiefpassnetzwerk wird vorzugsweise ein oder mehre Tiefpass-Filter verstanden. Ein Tiefpass-Filter ist ein Filter, der nur Frequenzen bis zu einer gewissen Höhe durchlässt. Darüber wird er zum Blockungsfilter.

Vorzugsweise werden unter Anpassungsnetzwerk eine Schaltung zur Anpassung der Impedanz zwischen einer Quelle für hochfrequente Signale und einem Verbraucher verstanden. Dadurch wird die Leistungsübertragung zwischen Quelle und Verbraucher optimiert.

Eine λ/4-Leitung ist vorzugsweise eine Transmissionsleitung zur Führung elektromagnetischer Wellen in Form einer Koplanar- oder Mikrostreifenleitung, deren Länge ein Viertel der Wellenlänge der zu übertragenden elektromagnetischen Welle beträgt und somit eine Transformation eines HF-Kurzschlusses in einen HF-Leerlauf und umgekehrt bewirkt.

Vorzugsweise umfasst das HF-Leistungstransistorgehäuse einen Flansch mit hoher elektrischer und thermischer Leitfähigkeit, einen darauf angebrachten elektrisch isolierenden Rahmen, der die wiederum darauf angebrachten zwei elektrischen Anschlüsse von dem Flansch isoliert, sowie einen elektrisch isolierenden Deckel, der den Inhalt des Gehäuses schützt.

Der vorgeschlagene HF-Leistungstransistor weist also getrennte NF- und HF-Massen auf, um ein gut vorhersagbares HF-Leistungsverstärker-Design mit potentialfreier NF-Masse zu ermöglichen. Herkömmliche gehäuste HF-Leistungstransistoren haben drei Anschlüsse, d.h. einen für das HF-Eingangssignal und die DC-Gate-Versorgung, einen zweiten für das HF-Ausgangssignal und die DC-Drain-Versorgung oder in einem ET-System auch für die NF-Drain-Versorgung und einen dritten für die gemeinsame Masse.

Der erfindungsgemäße Leistungstransistor mit potentialfreier Masse verfügt über vier oder mehr Anschlüsse. Die Anschlüsse für das HF-Eingangssignal und die Gleichspannungs-Gate-Versorgung sowie für das HF-Ausgangssignal und die Gleichspannungs-Drain-Versorgung sind die gleichen wie bei herkömmlichen gehäusten HF-Leistungstransistoren.

Der Unterschied für den erfindungsgemäßen HF-Leistungstransistor besteht darin, dass der Anschluss für die herkömmliche gemeinsame Masse von HF und DC&NF nun nur noch als HF-Masse dient. Der Anschluss für die potentialfreie DC&NF-Masse ist durch mindestens einen zusätzlichen Anschluss (zumindest den vierten Anschluss) realisiert. Aus diesem Grund sind mindestens vier aus dem Gehäuse herausführende Anschlüsse erforderlich.

Für den erfindungsgemäßen HF-Leistungstransistor mit potentialfreier NF-Masse erfolgt die Trennung der NF- und HF-Massen beispielsweise durch Kopplung des HF-Signals an die Systemmasse über einen Kondensator mit ausreichender Reihenresonanzfrequenz, der vorzugsweise einen HF-Kurzschluss und DC&NF-Leerlauf bereitstellt. Die Bandbreite des HF-Kurzschlusses ist hauptsächlich abhängig vom Qualitätsfaktor des Kondensators.

Der Transistor wird zusammen mit einem (bondfähigen) Kondensator oder einer Anzahl von Kondensatoren parallel in das Gehäuse eingebaut. Diese Lösung ist praktikabel, solange das Gehäuse groß genug ist, um sowohl den Transistor als auch den/die Kondensator(en) aufzunehmen, und nicht zu groß, um eine Grenze bspw. für die parasitären Induktivitäten von Verbindungsbonddrähten, welche das Induktive Element darstellen, festzulegen. Insbesondere eventuell verwendete Bonddrähte zwischen dem Sourcekontakt des Transistors und dem Kondensator haben einen wesentlichen Einfluss auf den HF-Kurzschluss.

Der erfindungsgemäße Leistungstransistor ermöglicht:
(1) - eine separate Charakterisierung und Modellierung des gehäusten (d.h. von einem Gehäuse umgeben), massegetrennten HF-Leistungstransistors an einer festen Schnittstelle, d.h. den mindestens vier aus dem Gehäuse herausführenden Anschlüssen;
(2) - einfaches und schnelles HF-Leistungsverstärker-Design durch Verwendung des erfindungsgemäßen HF-Leistungstransistors wie ein konventionell gehäuster HF-Leistungstransistor mit nur mindestens einem zusätzlichen Anschluss für die NF-Masse, ohne dass für die Montage besondere Ausrüstung und Wissen erforderlich sind;
(3) - Schutz vor mechanischen Beschädigungen durch einen Deckel als Teil des Gehäuses;
(4) - einfache und schnelle Reparatur eines HF-Leistungsverstärkers mit beschädigtem Transistor durch einfachen Austausch des gehäusten beschädigten Transistors mit einem neuen Transistor.

Das Leistungstransistorgehäuse umfasst vorzugsweise einen Flansch mit hoher elektrischer und thermischer Leitfähigkeit, vorzugsweise einen darauf angebrachten elektrisch isolierenden Rahmen, der die wiederum vorzugsweise darauf angebrachten zwei elektrischen Anschlüsse von dem Flansch isoliert, sowie vorzugsweise einen elektrisch isolierenden Deckel, der den Inhalt des Gehäuses schützt.

Das Merkmal "aus dem Gehäuse herausführen" in Bezug auf die Anschlüsse ist so zu verstehen, dass eine elektrische Verbindung mit einem externen Anschluss oder einer Masse für den jeweiligen Anschluss der mindestens vier Anschlüsse ermöglicht wird.

Der Begriff Transistor allein betrifft im Rahmen dieser Anmeldung lediglich den Transistor als einzelnes Schaltungselement im erfindungsgemäßen Leistungstransistor, wobei letzterer beispielsweise auch den Kondensator und das Gehäuse umfasst. Der Begriff Kondensator ist im Rahmen diese Anmeldung breit ausgelegt und kann auch ein anderes Schaltungselement, das dessen Funktionalität übernimmt, darstellen.

In einer bevorzugten Ausführungsform umfasst das induktive Element einen Bonddraht oder mehrere parallel geschaltete Bonddrähte. Vorzugsweise umfasst das induktive Element eine Vielzahl von Bonddrähten. Die Länge und Anzahl der Bonddrähte richtet sich nach dem zu überbrückenden Abstand zwischen dem Transistor und den zu verbindenden Elementen oder Anschlüssen und der benötigten Stromtragfähigkeit und kann außerdem entsprechend der gewünschten Induktivität des induktiven Elements variiert werden.

In einer weiteren bevorzugten Ausführungsform ist der Kondensator ein Einschichtkondensator. Die DC- & NF- / HF-Frequenztrennung am Sourcekontakt des Transistors wird dann durch mindestens einen, vorzugsweise bondfähigen, Einschichtkondensator mit entsprechender Kapazität und Reihenresonanzfrequenz erreicht. Der Kondensator ist vorzugsweise so nah wie möglich an dem Sourcekontakt des Transistors gebondet, wodurch ein HF-Kurzschluss zur Systemmasse bereitgestellt wird.

Vorzugsweise umfasst der Hochfrequenz-Leistungstransistor mindestens zwei parallel geschaltete Kondensatoren zwischen dem dritten Anschluss und dem Sourcekontakt.

Es ist bevorzugt, wenn der Transistor und der Kondensator in einem integrierten Schaltkreis, noch bevorzugter in einem MMIC (engl. monolithic microwave integrated circuit, dt. monolitisch integrierte Mikrowellenschaltung), kombiniert sind. Ein MMIC ist in der Hochfrequenztechnik eine spezielle Klasse von integrierten Schaltkreisen. Dabei werden alle aktiven und passiven Komponenten auf einem Halbleitersubstrat realisiert (Dicke vorzugsweise zwischen 50 µm und 350 µm). Die Miniaturisierung ermöglicht Schaltungen bis in den Bereich der Millimeterwellen. Der Transistor und der Kondensator, über den die Verbindung zur HF-Masse (insb. zur Systemmasse) erfolgt, sind dann beide innerhalb desselben integrierten Schaltkreises (MMIC) realisiert. Der MMIC umfasst also funktionell den Transistor und den Kondensator und ist von dem Gehäuse zumindest teilweise umschlossen. In diesem Fall wird auch ein induktives Element (insbesondere Bonddrähte) verwendet, um den MMIC zumindest mit dem vierten Anschluss zu verbinden, aber die Eigenschaften des HF-Kurzschlusses werden durch den MMIC-Aufbau gegeben (der die Funktion des Kondensators übernimmt bzw. diesen umfasst) und ist daher nicht von der Baugruppe im Gehäuse abhängig.

In einer weiteren bevorzugten Ausführungsform ist der dritte Anschluss mit mindestens einem elektrisch leitfähigen Flansch, vorzugsweise mit zwei gegenüberliegenden elektrisch leitfähigen Flanschen verbunden. Dadurch wird eine Verbindung mit einer Systemmasse (beispielsweise über einen kontaktierten Wärmetauscher) erleichtert.

Es ist bevorzugt, wenn der Hochfrequenz-Leistungstransistor einen fünften Anschluss umfasst, der über mindestens ein induktives Element an den Sourcekontakt angeschlossen ist, sodass der dritte Anschluss eine Hochfrequenz-Masse bereitstellt und der vierte Anschluss und der fünfte Anschluss gemeinsam eine potentialfreie Niederfrequenz-Masse und Source-Gleichspannungsversorgung bereitstellen.

Die oben genannte Aufgabe wird auch durch einen Hochfrequenz-Leistungstransistor nach einer der vorstehenden Ausführungsformen und zwei auf gegenüberliegenden Seiten des Hochfrequenz-Leistungstransistors angeordnete gedruckte Leiterplatten gelöst.

Vorzugsweise ist der erste Anschluss an eine Leiterbahn der ersten gedruckten Leiterplatte angeschlossen, wobei der zweite Anschluss, der vierte Anschluss, sowie gegebenenfalls der fünfte Anschluss, an Leiterbahnen der zweiten Leiterplatte angeschlossen sind. Die Leiterbahnen der gedruckten Leiterplatten stellen dann die externen Verbindungen für den ersten, zweiten, vierten und ggf. den fünften Anschluss (oder mehr) bereit. Vorzugsweise stellt eine Leiterplatte ein Eingangsanpassungsnetzwerk und die zweite ein Ausgangsanpassungsnetzwerk bereit.

In einer weiteren Ausführungsform umfasst vorzugsweise eine gemeinsame Leiterplatte ein Eingangsanpassungsnetzwerk und ein Ausgangsanpassungsnetzwerk.

Es ist bevorzugt, wenn der dritte Anschluss, vorzugsweise über mindestens einen Flansch, an einen Kühlkörper des Hochfrequenz-Leistungsverstärkers angeschlossen ist, der die Systemmasse für den Hochfrequenz-Leistungsverstärker definiert. Damit lässt sich sowohl die HF-Masse über die Systemmasse definieren als auch die mechanische und thermische Verbindung des Leistungstransistors an das System bereitstellen.

### Kurzbeschreibung der Figuren

Die oben beschriebenen Eigenschaften, Merkmale und Vorteile dieser Erfindung sowie die Art und Weise, wie diese erreicht werden, werden klarer und deutlicher verständlich im Zusammenhang mit der folgenden Beschreibung der Ausführungsbeispiele, die im Zusammenhang mit den Zeichnungen näher erläutert werden. Es zeigen:
- Figur 1A: eine Draufsicht eines herkömmlichen gehäusten HF-Leistungstransistors mit Deckel,
- Figur 1B: ein Blockschaltbild eines nach dem Stand der Technik bekannten gehäusten HF-Leistungstransistors,
- Figur 1C: eine Draufsicht eines herkömmlichen gehäusten HF-Leistungstransistors ohne Deckel mit darin enthaltenem Transistorchip, elektrisch leitfähigen Bondstützpunkten und Bonddrähten,
- Figur 1D: ein Blockschaltbild eines herkömmlichen gehäusten HF-Leistungstransistors mit Ein- und Ausgangsanpassungsnetzwerken innerhalb des Gehäuses,
- Figur 2A: ein Blockschaltbild des gehäusten HF-Leistungstransistors aus Fig. 1B, verbunden mit einer Platine, die, entsprechend dem Stand der Technik, Anpassungsnetzwerke sowie den DC- & NF- / HF-Diplexer mit angeschlossenem Versorgungsnetzwerk enthält,
- Figur 2B: ein Blockschaltbild des gehäusten HF-Leistungstransistors aus Fig. 1B, verbunden mit einer Platine, die, entsprechend dem Stand der Technik, Anpassungsnetzwerke, den DC- & NF- / HF-Diplexer mit angeschlossenem Versorgungsnetzwerk für die Drainversorgung des Transistors sowie weitere für den potentialfreien Betrieb notwendige Schaltungsteile enthält,
- Figur 3A: ein Blockschaltbild einer Ausführungsform des erfindungsgemäßen gehäusten HF-Leistungstransistors mit internem HF-Bypassnetzwerk zur Systemmasse,
- Figur 3B: ein Blockschaltbild einer weiteren Ausführungsform des erfindungsgemäßen gehäusten HF-Leistungstransistors mit internem HF-Bypassnetzwerk zur Systemmasse sowie integrierten Ein- und Ausgangsanpassungsnetzwerken,
- Figur 4A: ein Blockschaltbild einer weiteren erfindungsgemäßen Ausführungsform des gehäusten HF-Leistungstransistors mit internem HF-Bypassnetzwerk zur Systemmasse und internem DC- & NF-Tiefpassnetzwerk zum DC- & NF-Masseanschluss,
- Figur 4B: ein Blockschaltbild einer weiteren Ausführungsform des erfindungsgemäßen gehäusten HF-Leistungstransistors mit internem HF-Bypassnetzwerk zur Systemmasse und internem DC- & NF-Tiefpassnetzwerk zum DC- & NF-Masseanschluss sowie integrierten Ein- und Ausgangsanpassungsnetzwerken,
- Figur 5A: ein physikalisches Ersatzschaltbild einer Ausführungsform des erfindungsgemäßen HF-Leistungstransistors,
- Figur 5B: ein elektrisches Ersatzschaltbild der Ausführungsform des erfindungsgemäßen HF-Leistungstransistors aus Fig. 5A,
- Figur 5C: ein Realisierungsbeispiel des erfindungsgemäßen gehäusten HF-Leistungstransistors mit einem DC- & NF-Masseanschluss,
- Figur 5D: ein Realisierungsbeispiel des erfindungsgemäßen gehäusten HF-Leistungstransistors mit zwei DC- & NF-Masseanschlüssen,
- Figur 6A: ein physikalisches Ersatzschaltbild einer weiteren Ausführungsform des erfindungsgemäßen HF-Leistungstransistors mit internen Ein- und Ausgangsanpassungsnetzwerken,
- Figur 6B: ein elektrisches Ersatzschaltbild der weiteren Ausführungsform des erfindungsgemäßen HF-Leistungstransistors mit internen Ein- und Ausgangsanpassungsnetzwerken aus Fig. 6A
- Figur 7A: ein physikalisches Ersatzschaltbild einer weiteren Ausführungsform des erfindungsgemäßen HF-Leistungstransistors, bei der das HF-Bypassnetzwerk zur Systemmasse auf demselben Chip wie der Transistor realisiert ist,
- Figur 7B: ein elektrisches Ersatzschaltbild der weiteren Ausführungsform des erfindungsgemäßen HF-Leistungstransistors, bei der das HF-Bypassnetzwerk zur Systemmasse auf demselben Chip wie der Transistor realisiert ist, aus Fig. 7A,
- Figur 7C: ein Realisierungsbeispiel des erfindungsgemäßen gehäusten HF-Leistungstransistors mit einem DC- & NF-Masseanschluss,
- Figur 8: eine Ausführungsform eines erfindungsgemäßen HF-Leistungstransistors gemäß Figur 5C mit umgebenden Platinen,
- Figur 8A: ein physikalisches Ersatzschaltbild einer weiteren Ausführungsform des erfindungsgemäßen HF-Leistungstransistors mit internen Ein- und Ausgangsanpassungsnetzwerken, bei der das HF-Bypassnetzwerk zur Systemmasse auf demselben Chip wie der Transistor realisiert ist,
- Figur 8B: ein elektrisches Ersatzschaltbild der weiteren Ausführungsform des erfindungsgemäßen HF-Leistungstransistors mit internen Ein- und Ausgangsanpassungsnetzwerken, bei der das HF-Bypassnetzwerk zur Systemmasse auf demselben Chip wie der Transistor realisiert ist, aus Fig. 8A,
- Figur 9A: ein physikalisches Ersatzschaltbild einer weiteren Ausführungsform des erfindungsgemäßen HF-Leistungstransistors, bei der das HF-Bypassnetzwerk zur Systemmasse und das DC- & NF-Tiefpassnetzwerk zum DC- & NF-Anschluss auf demselben Chip wie der Transistor realisiert sind,
- Figur 9B: ein elektrisches Ersatzschaltbild der weiteren Ausführungsform des erfindungsgemäßen HF-Leistungstransistors, bei der das HF-Bypassnetzwerk zur Systemmasse und das DC- & NF-Tiefpassnetzwerk zum DC- & NF-Anschluss auf demselben Chip wie der Transistor realisiert sind, aus Fig. 9A,
- Figur 9C: ein elektrisches Ersatzschaltbild einer weiteren Ausführungsform des erfindungsgemäßen HF-Leistungstransistors, bei der das HF-Bypassnetzwerk zur Systemmasse und eine kurzgeschlossene λ/4-Leitung zum DC- & NF-Anschluss auf demselben Chip wie der Transistor realisiert sind,
- Figur 10: ein Blockschaltbild einer Ausführungsform des erfindungsgemäßen potentialfreien gehäusten HF-Leistungstransistors aus Fig. 4A, verbunden mit einer Platine, die Anpassungsnetzwerke sowie den DC- & NF- / HF-Diplexer für die Drainversorgung des Transistors mit angeschlossenem Versorgungsnetzwerk enthält, sowie einer zusätzlichen externen Schaltung für die galvanisch getrennte Gateversorgung des Transistors, die für den potentialfreien Betrieb notwendig ist.

### Detaillierte Beschreibung der Erfindung

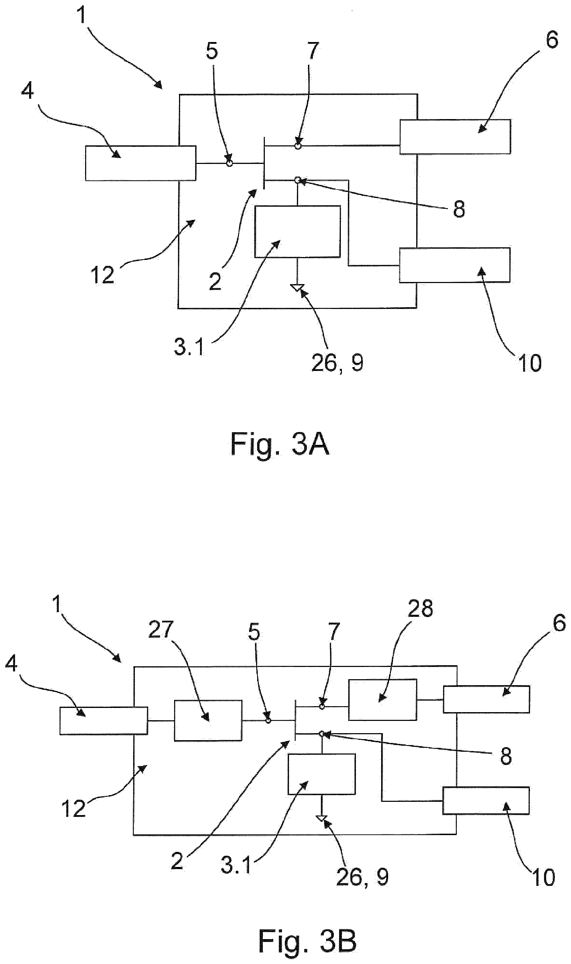

Fig. 3A und 3B zeigen Blockschaltbilder zweier erfindungsgemäßer Ausführungsformen des HF-Leistungstransistors 1 mit bzw. ohne Anpassungsnetzwerken 27, 28 und mit HF-Bypassnetzwerk 3.1 zur Systemmasse 26. Funktionsblöcke mit gleichen Bezeichnungen in beiden Figuren gleichen einander. In Fig. 3A und 3B ist ein HF-Leistungstransistor 1 in ein Gehäuse 12 montiert. In beiden Figuren ist ein Feldeffekttransistor 2 (FET) dargestellt. Anstelle dessen kann jedoch, wie bereits erwähnt, auch ein Bipolartransistor (BJT) verwendet werden. Außerdem können anstelle nur eines Transistors 2 mehrere Transistoren in dem Gehäuse 12 montiert und parallel geschaltet werden. Der Gatekontakt 5 des FETs ist dem Stand der Technik entsprechend unmittelbar oder durch das Eingangsanpassungsnetzwerk 27 mit dem Eingangsanschluss 4 verbunden. Ebenso dem Stand der Technik entsprechend ist der Drainkontakt 7 des FETs 2 unmittelbar oder durch das Ausgangsanpassungsnetzwerk 28 mit dem Ausgangsanschluss 6 verbunden. Entgegen dem Stand der Technik ist der Sourcekontakt 8 des FETs 2 nicht direkt mit der Systemmasse 26 verbunden. Anstelle dessen ist er über ein HF-Bypassnetzwerk 3.1 mit der Systemmasse 26, die die HF-Masse 9,26 darstellt, verbunden und über eine zusätzliche Verbindung mit dem DC- & NF-Masseanschluss 10 verbunden. In beiden Ausführungsformen wird das HF-Bypassnetzwerk 3.1 mittels eines nach Systemmasse 26 geschalteten Kondensators 3 realisiert. Die Verbindung mit dem DC- & NF-Masseanschluss 10 wird durch Drahtbonden erreicht. Die Funktionalität des DC- & NF- / HF-Diplexers 30 wird durch ein auf der Platine befindliches DC- & NF-Tiefpassnetzwerk 3.2 vervollständigt. In der Schaltung für potentialfreien Betrieb in Fig. 2B, die dem Stand der Technik entspricht, ist das HF-Bypassnetzwerk 3.1 außerhalb des Transistorgehäuses 12 auf der Platine 29 platziert, wodurch ein gewisser Abstand zum eigentlichen Transistor 2 entsteht. Wie bereits erwähnt, erleichtert die HF-Masseverbindung 9,26 innerhalb des Gehäuses 12 den Entwurf eines HF-Leistungstransistors 1 und erhöht die Bandbreite des HF-Bypassnetzwerkes 3.1 und somit auch die Linearität der Transistorschaltung für breitbandige Signale.

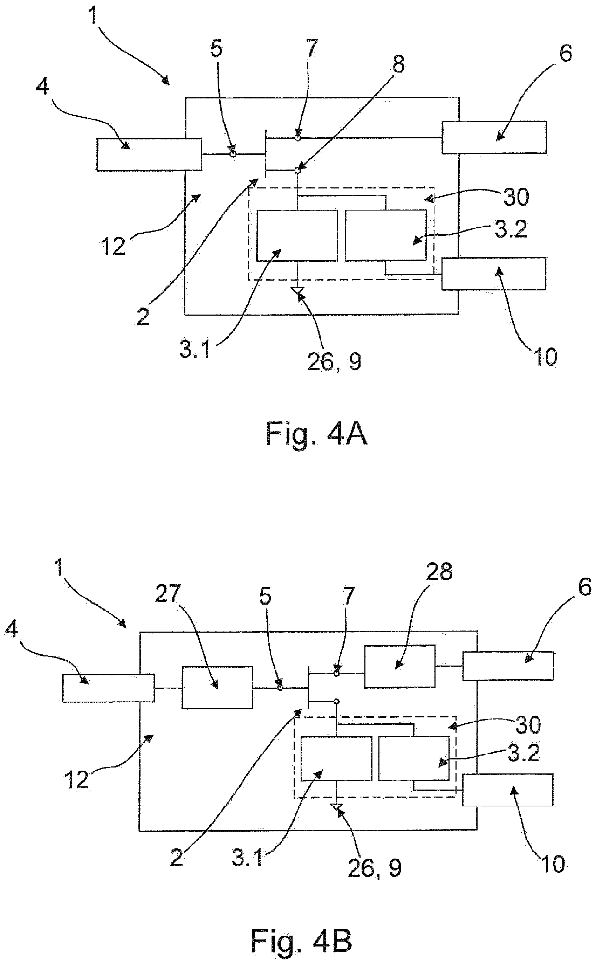

Die Blockdiagramme der Fig. 4A und 4B gleichen denen der Fig. 3A und 3B bis auf ein zusätzliches DC- und NF-Tiefpassnetzwerk 3.2, welches zwischen dem Sourcekontakt 8 des FETs 2 und dem DC- & NF-Masseanschluss 10, 26.1 eingefügt ist um die HF-Isolation und NF-Bandbreite des Transistors 2 zu verbessern. Die Funktionalität des DC- & NF- / HF-Diplexer 30 ist somit vollständig innerhalb des Transistorgehäuses 12 realisiert.

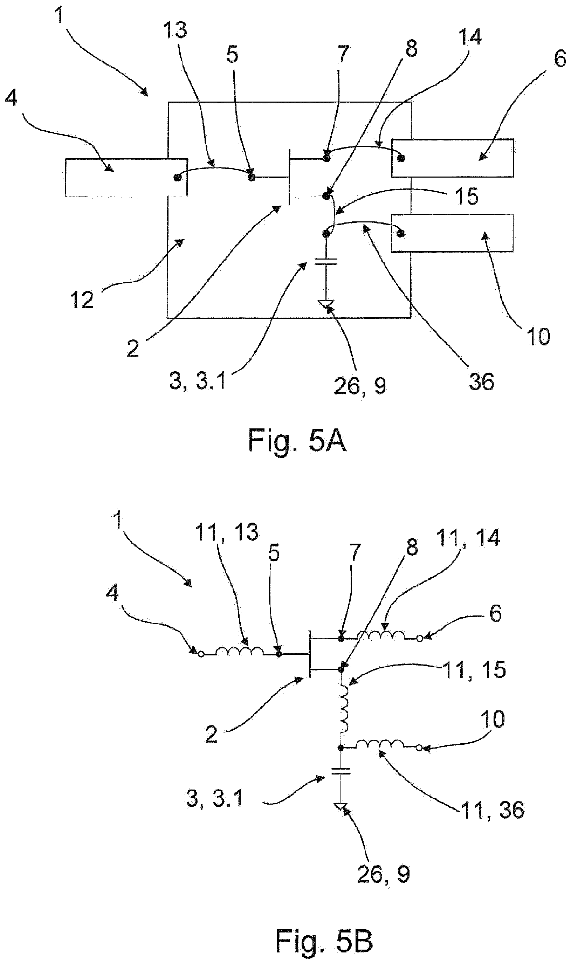

Fig. 5A und 5B sind physikalische bzw. elektrische Ersatzschaltbilder der in Fig. 3A dargestellten Ausführungsform des erfindungsgemäßen HF-Leistungstransistors 1, wobei die elektrischen Verbindungen durch die in Fig. 5A gezeigten Bonddrähte 36, 13, 14, 15 hergestellt werden, die ihrerseits wiederum die in Fig. 5B gezeigten Induktivitäten 11 bilden. Das in Fig. 3A dargestellte HF-Bypassnetzwerk 3.1 wird durch den in 5A und 5B gezeigten Kondensator 3 gebildet, der wiederum einen diskreten, bondbaren ein- oder mehrlagigen Kondensator darstellt. Anstelle eines Kondensators 3 können auch mehrere parallel geschaltete Kondensatoren verwendet werden, die nebeneinander im Gehäuse 12 platziert werden. Die in Fig. 5A dargestellte erfindungsmäße Ausführungsform des HF-Bypassnetzwerkes 3.1 wird durch einen Kurzschlusskondensator 3 nach Systemmasse 26 gebildet, der bei der HF-Trägerfrequenz optimale Eigenschaften besitzt und durch Bonddrähte 15, 11 mit dem Transistor 2 und dem DC- & NF-Masseanschluss 10 verbunden ist. Die Größe der dadurch eingebrachten Induktivitäten 15, 11 trägt zur HF-Isolation und NF-Bandbreite des Diplexers 30 bei. Die kleine Induktivität 15, 11 stellt zusammen mit dem Kurzschlusskondensator 3 einen optimalen HF-Bypass 3.1 zur Systemmasse 26 dar. In einer anderen Ausführungsform des erfindungsgemäßen HF-Leistungstransistors wird, wie in Fig. 4A gezeigt, die gesamte Funktionalität des DC- & NF- / HF-Diplexers 30 im Transistorgehäuse 12 untergebracht, wobei das HF-Bypassnetzwerk 3.1 unverändert bleibt, aber eine zusätzliche Induktivität 36, 11 zwischen der oberen Elektrode des Kondensators 3, der mit dem Sourcekontakt 8 verbunden ist, und dem DC- & NF-Masseanschluss 10 in das Gehäuse 12 eingefügt wird. Diese Induktivität 36, 11 muss die entsprechende Größe aufweisen, um zusammen mit der Induktivität 15, 11 eine gute HF-Isolation und NF-Bandbreite zu realisieren. Diese zusätzliche Induktivität 36, 11 kann erfindungsgemäß entweder durch eine erhöhte Anzahl von Bonddrähten oder das Einfügen einer diskreten Spule erreicht werden.

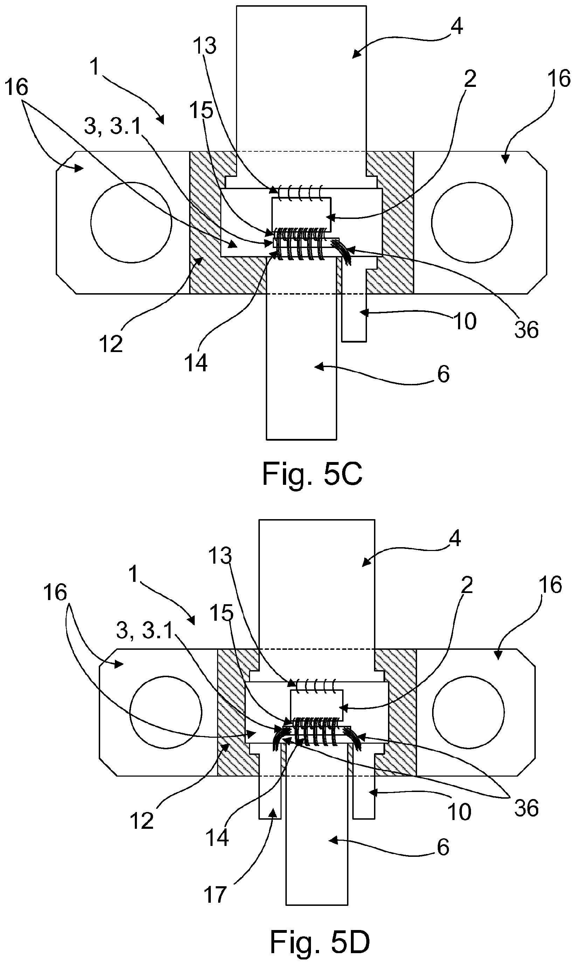

Fig. 5C zeigt eine erste Ausführungsform des erfindungsgemäßen HF-Leistungstransistors 1. Das gezeigte HF-Leistungstransistorgehäuse 12 ähnelt dem in Fig. 1A-C gezeigten und umfasst einen Flansch 16 mit hoher elektrischer und thermischer Leitfähigkeit, einen darauf angebrachten keramischen Rahmen des Gehäuses 12, der die wiederum darauf angebrachten drei elektrischen Anschlüsse 4, 6, 10 von dem Flansch 16 isoliert. Der im Gehäuse 12 enthaltene Transistor 2 wird zusammen mit einem bondbaren, einlagigen Kondensator 3 auf dem Flansch 16 innerhalb des keramischen Rahmens des Gehäuses 12 platziert. Es werden Bonddrähte 13 verwendet um den Eingangsanschluss 4 mit dem Gatekontakt 5 des FETs 2 (oder dem Basiskontakt eines BJTs), den Drainkontakt 7 des FETs 2 (oder Emitterkontakt eines BJTs) mit dem Ausgangsanschluss 6 sowie den Sourcekontakt 8 des FETs 2 (oder Kollektorkontakt eines BJTs) mit der oberen Elektrode des Kondensators 3 und weiter mit dem DC- & NF-Masseanschluss 10 zu verbinden. Bei dem dargestellten Transistorchip handelt es sich um einen Transistor ohne Vias, sodass die Trennung von DC- & NF- / HF-Masse erreicht werden kann. Optional kann ein keramischer Deckel 12.1, wie in Fig. 1A gezeigt, verwendet werden um den Inhalt des Gehäuses 12 zu schützen.

Fig. 5D zeigt eine zweite Ausführungsform des erfindungsgemäßen HF-Leistungstransistors 1, die der in Fig. 5C ähnelt, mit dem Unterschied, dass anstelle des einen in Fig. 5C gezeigten DC- & NF-Masseanschlusses 10 zwei DC- & NF-Masseanschlüsse 10 enthalten sind und folglich auch zusätzliche Bonddrähte 36, die die obere Elektrode des Kondensators 3 mit dem zweiten DC- & NF-Masseanschluss 10 verbinden.

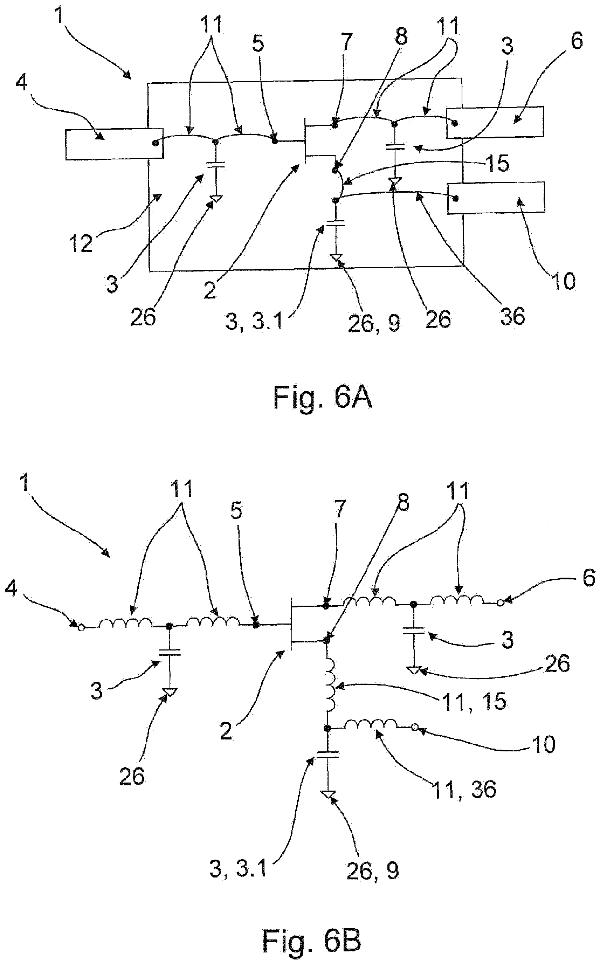

Fig. 6A und 6B sind physikalische bzw. elektrische Ersatzschaltbilder der in Fig. 3B dargestellten Ausführungsform des erfindungsgemäßen HF-Leistungstransistors 1 mit integrierten Anpassungsnetzwerken 27, 28, wobei Bonddrähte 36, 13 14, 15 als induktive Elemente und diskrete ein- oder mehrlagige Kondensatoren 3 als kapazitive Elemente eingesetzt werden. Die Anpassungsnetzwerke 27, 28 können bezüglich des HF-Leistungstransistors 1 ein- und/oder ausgangsseitig implementiert werden. Das in Fig. 3B gezeigte Eingangsanpassungsnetzwerk 27 ist in Fig. 6A mit einem diskreten ein- oder mehrlagigen Kurzschlusskondensator 3 realisiert, welcher durch Drahtbonden sowohl mit dem Eingangsanschluss 4 als auch mit dem Gatekontakt 5 des Transistors 2 verbunden ist. Anstelle eines Kondensators 3 können auch mehrere parallel geschaltete Kondensatoren 3 verwendet werden. Das in Fig. 6A gezeigte Eingangsanpassungsnetzwerk 27 kann um weitere Stufen in Form induktiver und/oder kapazitiver Elemente erweitert werden. Das in Fig. 3B gezeigte Ausgangsanpassungsnetzwerk 28 ist in Fig. 6A mit einem diskreten ein- oder mehrlagigen Kurzschlusskondensator 3 realisiert, welcher durch Drahtbonden sowohl mit dem Drainkontakt 7 des Transistors 2 als auch mit dem Ausgangsanschluss 6 verbunden ist. Anstelle eines Kondensators 3 können auch mehrere parallel geschaltete Kondensatoren 3 verwendet werden. Das in Fig. 6A gezeigte Ausgangsanpassungsnetzwerk 28 kann um weitere Stufen in Form induktiver und/oder kapazitiver Elemente erweitert werden. Das in Fig. 3B gezeigte HF-Bypassnetzwerk 3.1 ist in Fig. 6A mit einem ein- oder mehrlagigen Kondensator 3 realisiert, der bei der HF-Trägerfrequenz optimale Eigenschaften besitzt. Die obere Elektrode des Kondensators 3 ist durch Bonddrähte 15 mit dem Sourcekontakt 8 des Transistors 2 verbunden. Die untere Elektrode des Kondensators 3 ist direkt mit dem Flansch 16 des Transistorgehäuses 12 verbunden, welcher die System- bzw. HF-Masse 9,26 darstellt. In einer typischen Ausführungsform stellen die Induktivitäten 36 und 15 die Induktivitäten der für die elektrischen Verbindungen verwendeten Bonddrähte 36, 15 dar. Zugleich trägt deren Größe zur HF-Isolation und NF-Bandbreite des Diplexers 30 bei. Die kleine Induktivität 15 stellt zusammen mit dem Kurzschlusskondensator 3 einen optimalen HF-Bypass 3.1 zur Systemmasse 26 dar. In einer anderen Ausführungsform des erfindungsgemäßen HF-Leistungstransistors wird, wie in Fig. 4B gezeigt, die gesamte Funktionalität des DC- & NF- / HF-Diplexers 30 im Transistorgehäuse 12 untergebracht, wobei das HF-Bypassnetzwerk 3.1 unverändert bleibt, aber eine zusätzliche Induktivität 36, 11 zwischen der oberen Elektrode des Kondensators 2, der mit dem Sourcekontakt 8 verbunden ist, und dem DC- & NF-Masseanschluss 10 in das Gehäuse 12 eingefügt wird. Diese Induktivität 36, 11 muss die entsprechende Größe aufweisen, um zusammen mit der Induktivität 15, 11 eine gute HF-Isolation und NF-Bandbreite zu realisieren. Diese zusätzliche Induktivität 36, 11 kann erfindungsgemäß entweder durch eine erhöhte Anzahl von Bonddrähten oder das Einfügen einer diskreten Spule erreicht werden.

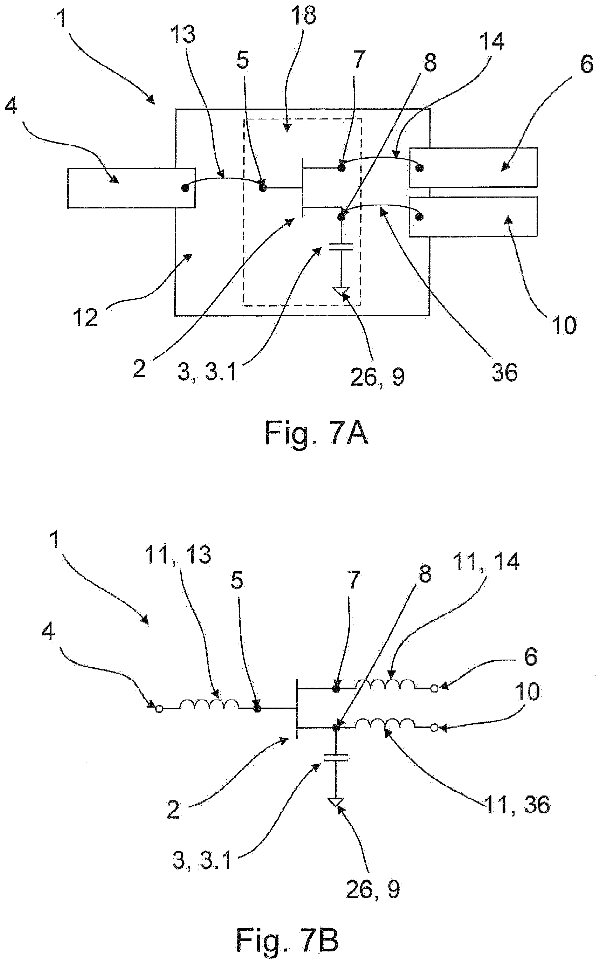

Fig. 7A und 7B sind physikalische bzw. elektrische Ersatzschaltbilder einer weiteren auf Fig. 3A basierenden Ausführungsform des erfindungsgemäßen HF-Leistungstransistors 1, die den Fig. 5A und 5B ähneln, bei denen aber der HF-Bypasskondensator 3.1 als Metall-Isolator-Metall- (MIM) Kondensator 3 auf demselben Chip 18 wie der Transistor 2 realisiert ist. Dadurch wird der induktive Anteil des HF-Bypassnetzwerkes 3.1 minimiert und die HF-Isolation und NF-Bandbreite weiter verbessert.

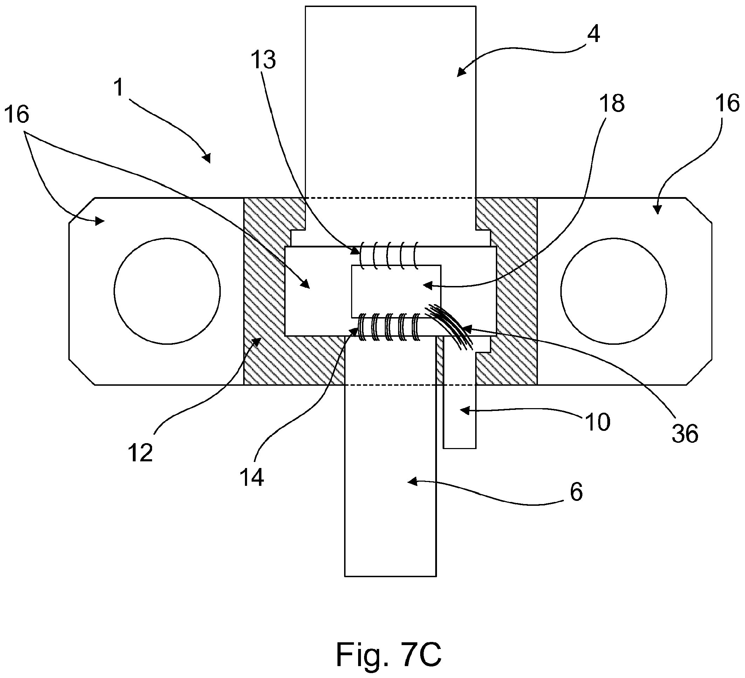

Fig. 7C zeigt eine dritte Ausführungsform des erfindungsgemäßen HF-Leistungstransistors 1 gemäß Fig. 7A und 7B, die der in Fig. 5C ähnelt, mit dem Unterschied, dass anstelle des Transistorchips mit separatem Kondensator 3 ein Transistorchip mit integriertem MIM-Kondensator gemäß Fig. 7A und 7B im Gehäuse 12 platziert wird. Die Anzahl der benötigten Bonddrähte ist somit gegenüber Fig. 5C reduziert.

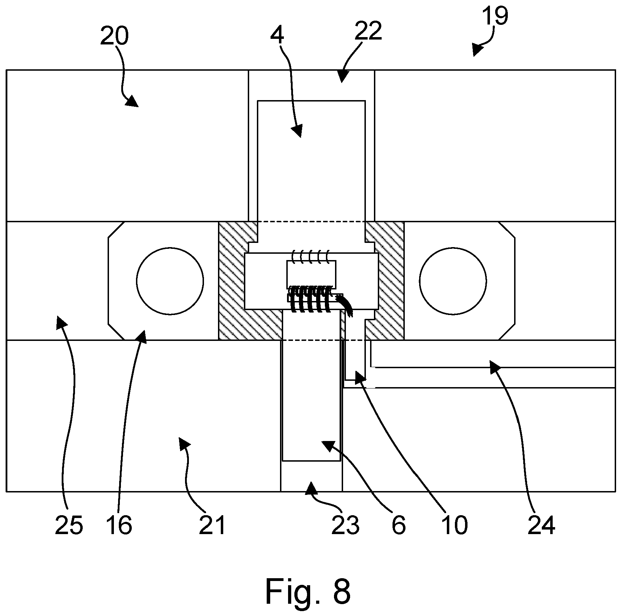

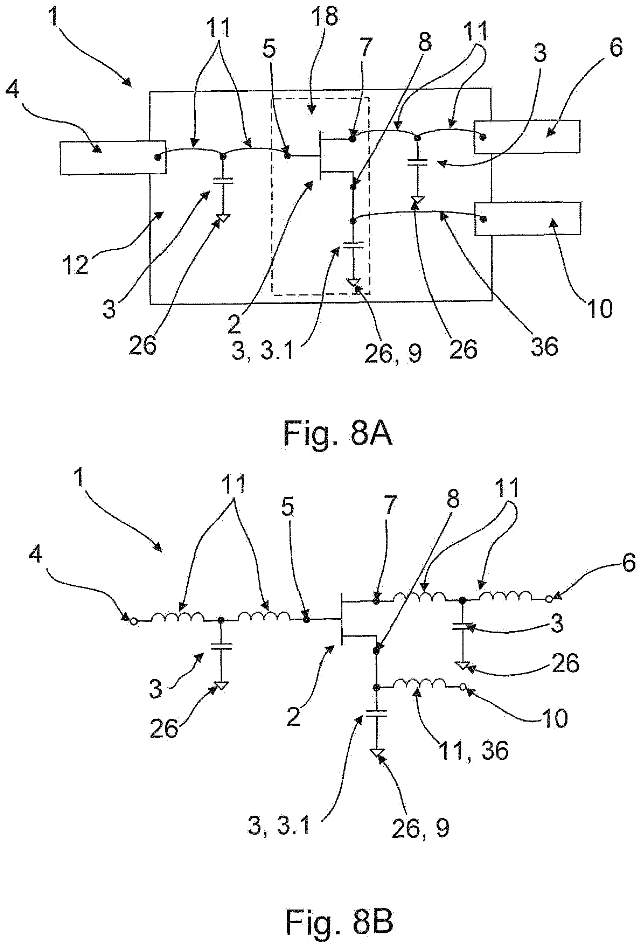

Figur 8 zeigt eine Ausführungsform eines erfindungsgemäßen HF-Leistungstransistors 1 gemäß der Ausführungsform der Figur 5C und zwei auf gegenüberliegenden Seiten des Hochfrequenz-Leistungstransistors 1 angeordnete gedruckte Leiterplatten 20, 21. Der erste Anschluss 4 ist an eine Leiterbahn 22 der ersten gedruckten Leiterplatte 20 angeschlossen. Der zweite Anschluss 6 und der vierte Anschluss 10 (sowie gegebenenfalls der fünfte Anschluss 17, hier nicht gezeigt) sind an entsprechende Leiterbahnen 23, 24 der zweiten Leiterplatte 21 angeschlossen. Die Leiterbahnen 22, 23, 24 der gedruckten Leiterplatten 20, 21 stellen die externen Verbindungen für den ersten, zweiten, vierten und ggf. den fünften (oder weitere) Anschluss 4, 6, 10, 17 bereit.

Der dritte Anschluss 9 ist über mindestens einen Flansch 16 an einen Kühlkörper 25 des Hochfrequenz-Leistungstransistors 1 angeschlossen, der die Systemmasse für den Hochfrequenz-Leistungsverstärker definiert. Der Leistungstransistor 1 ist hier am Beispiel des Leistungstransistors 1 der Figur 5C dargestellt, aber dem Fachmann sind entsprechende Ausführungsformen für die Leistungstransistoren 1 der Figuren 5D und 7C ohne weiteres ersichtlich.

Fig. 8A und 8B sind physikalische und elektrische Ersatzschaltbilder einer anderen durch Fig. 3B dargestellten Ausführungsform des erfindungsgemäßen HF-Leistungstransistors 1, die den Fig. 6A und 6B ähneln, bei denen aber der HF-Bypasskondensator 3 als Metall-Isolator-Metall- (MIM) Kondensator auf demselben Chip 18 wie der Transistor 2 realisiert ist. Dadurch wird der induktive Anteil des HF-Bypassnetzwerkes 3.1 minimiert und die HF-Isolation und NF-Bandbreite weiter verbessert.

Das in Fig. 3B gezeigte Eingangsanpassungsnetzwerk 27 ist in Fig. 8A mit einem diskreten ein- oder mehrlagigen Kurzschlusskondensator 3 realisiert, welcher durch Drahtbonden sowohl mit dem Eingangsanschluss 4 als auch mit dem Gatekontakt 5 des Transistors 2 verbunden ist. Anstelle eines Kondensators 3 können auch mehrere parallel geschaltete Kondensatoren verwendet werden. Das in Fig. 8A gezeigte Eingangsanpassungsnetzwerk 27 kann um weitere Stufen in Form induktiver und/oder kapazitiver Elemente erweitert werden. Das in Fig. 3B gezeigte Ausgangsanpassungsnetzwerk 28 ist in Fig. 8A mit einem diskreten ein- oder mehrlagigen Kurzschlusskondensator 3 realisiert, welcher durch Drahtbonden sowohl mit dem Drainkontakt 7 des Transistors 2 als auch mit dem Ausgangsanschluss 6 verbunden ist. Anstelle eines Kondensators 3 können auch mehrere parallel geschaltete Kondensatoren verwendet werden. Das in Fig. 8A gezeigte Ausgangsanpassungsnetzwerk 28 kann um weitere Stufen in Form induktiver und/oder kapazitiver Elemente erweitert werden. In einer weiteren Ausführungsform des erfindungsgemäßen HF-Leistungstransistors 1 werden das Eingangs 27- und/oder Ausgangsanpassungsnetzwerk 28 auf demselben Chip 18 wie der Transistor 2 realisiert, indem MIM-Kondensatoren 3 auf dem Chip 18 mit dem Gate 5- bzw. Drainkontakt 7 verbunden werden und durch Drahtbonden mit den Eingangs 4- bzw. Ausgangsanschlüssen 6 des Transistorgehäuses 12 verbunden werden.

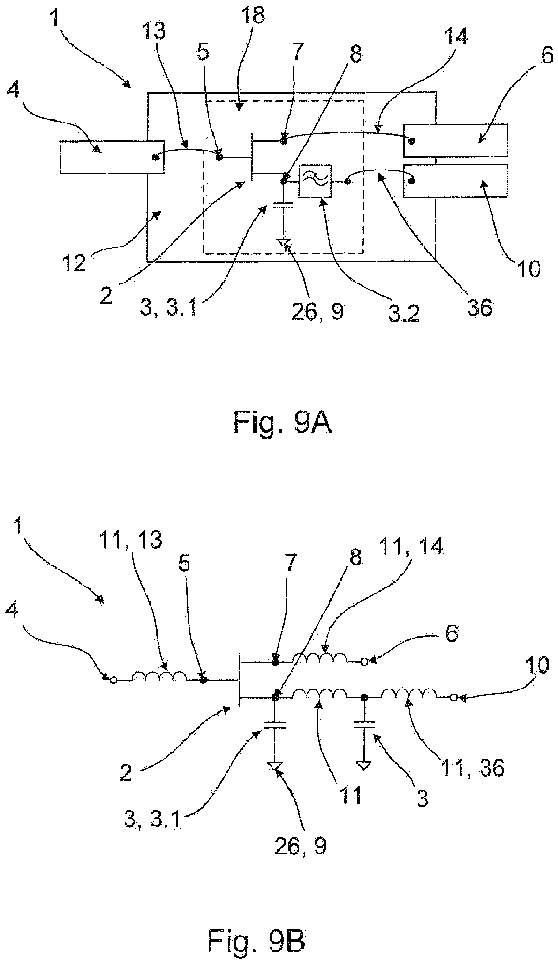

Fig. 9A ist das physikalische Ersatzschaltbild einer weiteren durch Fig. 4A dargestellten Ausführungsform des erfindungsgemäßen HF-Leistungstransistors 1, die den Ausführungsformen in Fig. 7A und 7B ähnelt, bei der aber die Funktion des DC- & NF-Tiefpassfilters 3.2 nicht durch die Anzahl und Länge der verwendeten Bonddrähte zwischen dem Sourcekontakt 8 und dem DC- & NF-Masseanschluss 10, sondern durch Einfügen einer geeigneten Filterstruktur 3.2 auf dem Transistorchip 18 realisiert wird.

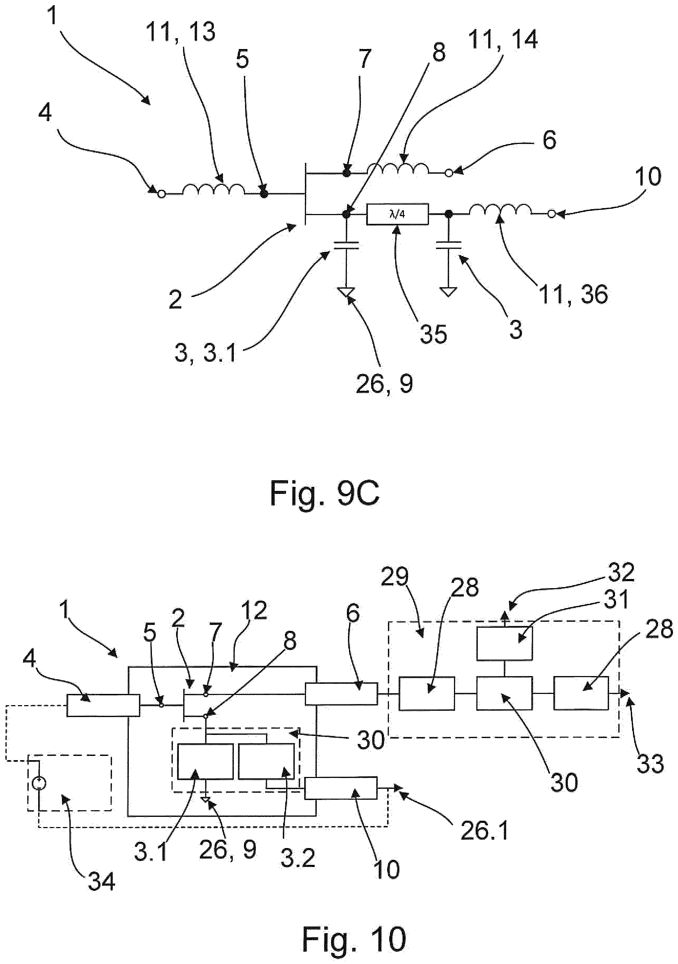

Fig. 9B und 9C sind elektrische Ersatzschaltbilder zweier Ausführungsformen des erfindungsgemäßen HF-Leistungstransistors 1 der Fig. 9A. In Fig. 9B wird die Filterstruktur 3.2 durch ein induktiv-kapazitives (LC) Filter auf dem Transistorchip 18 realisiert. Die DC- & NF-Verbindung zwischen dem Chip 18 und dem DC- & NF-Masseanschluss 10 wird durch Drahtbonden realisiert. In einer anderen Ausführungsform des erfindungsgemäßen HF-Leistungstransistors 1 wird das LC-Filter 3.2 auf einem separaten Chip realisiert, der durch Drahtbonden sowohl mit dem Sourcekontakt 8 des Transistors 2 als auch mit dem DC- & NF-Masseanschluss 10 verbunden wird. In Fig. 9C wird die HF-Isolation und NF-Bandbreite der Filterstruktur 3.2 verbessert, indem als Filter eine mit einem Kondensator kurzgeschlossene λ/4-Leitung 35 als DC- & NF-Leitung auf demselben Chip 18 wie der Transistor 2 implementiert wird, welche durch Drahtbonden 36, 11 mit dem DC- & NF-Masseanschluss 10 verbunden wird. In einer anderen Ausführungsform des erfindungsgemäßen HF-Leistungstransistors 1 wird die kurzgeschlossene λ/4-Leitung 35 auf einem separaten Chip realisiert, der durch Drahtbonden sowohl mit dem Sourcekontakt 8 des Transistors 2 als auch mit dem DC- & NF-Masseanschluss 10 verbunden wird. In einer weiteren Ausführungsform des erfindungsgemäßen HF-Leistungstransistors 1 werden in das Transistorgehäuse 12 zusätzlich zu dem Transistorchip 18 mit integriertem DC- & NF- / HF-Diplexer 30 Eingangs 27- und/oder Ausgangsanpassungsnetzwerke 28 montiert, wobei das Eingangsanpassungsnetzwerk 27 mit einem diskreten ein- oder mehrlagigen Kurzschlusskondensator 3 realisiert wird, welcher durch Drahtbonden sowohl mit dem Eingangsanschluss 4 als auch mit dem Gatekontakt 5 des Transistors 2 verbunden ist und das Ausgangsanpassungsnetzwerk 28 mit einem diskreten ein- oder mehrlagigen Kurzschlusskondensator 3 realisiert wird, welcher durch Drahtbonden sowohl mit dem Drainkontakt 7 des Transistors als auch mit dem Ausgangsanschluss 6 verbunden ist. Für beide Anpassungsnetzwerke 27, 28 können anstelle eines Kondensators 3 auch mehrere parallel geschaltete Kondensatoren verwendet werden. Beide Anpassungsnetzwerke 27, 28 können um weitere Stufen in Form induktiver und/oder kapazitiver Elemente erweitert werden. In einer weiteren Ausführungsform des erfindungsgemäßen HF-Leistungstransistors 1 werden das Eingangs 27- und/oder Ausgangsanpassungsnetzwerk 28 auf demselben Chip 18 wie der Transistor 2 realisiert, indem MIM-Kondensatoren auf dem Chip 18 mit dem Gate 5- bzw. Drainkontakt 7 verbunden werden und durch Drahtbonden mit den Eingangs 4- bzw. Ausgangsanschlüssen 6 des Transistorgehäuses 12 verbunden werden.

Figur 10 ist ein Blockschaltbild einer Ausführungsform des erfindungsgemäßen potentialfreien gehäusten HF-Leistungstransistors 1 aus Fig. 4A umgeben von einer Platine 29, die Anpassungsnetzwerke 28 sowie den DC- & NF- / HF-Diplexer 30 für die Drainversorgung des Transistors 1 mit angeschlossenem Versorgungsnetzwerk 31 enthält, sowie einer zusätzlichen externen Schaltung für die galvanisch getrennte Gateversorgung 34 des Transistors 1, die für den potentialfreien Betrieb notwendig ist. Fig. 10 verdeutlicht die Vorteile der Erfindung verglichen mit dem Stand der Technik.

Vorzugsweise sind alle induktiven Elemente 11 als Bond-Drähte ausgebildet.

### Bezugszeichenliste

- 1: Hochfrequenz-Leistungstransistor
- 2: Transistor
- 3: Kondensator
- 3.1: Bypassnetzwerk
- 3.2: Tiefpassnetzwerk
- 4: erster Anschluss (Eingangsanschluss)
- 5: Gatekontakt
- 6: zweiter Anschluss (Ausgangsanschluss)
- 7: Drainkontakt
- 8: Sourcekontakt
- 9: dritter Anschluss (HF-Masseverbindung)
- 10: vierter Anschluss (DC- & NF-Masseanschluss)
- 11: induktives Element
- 12: Gehäuse
- 12.1: Deckel
- 13: Bond-Drähte
- 14: Bond-Drähte
- 15: Bond-Drähte
- 16: Flansch
- 16.1: Bondstützpunkte
- 17: fünfter Anschluss
- 18: Integrierter Schaltkreis
- 19: Ausschnitt eines Hochfrequenzleistungsverstärkers: Hochfrequenz-Leistungstransistor mit umgebenden Platinen
- 20: gedruckte Leiterplatte
- 21: gedruckte Leiterplatte
- 22: Leiterbahn
- 23: Leiterbahn
- 24: Leiterbahn
- 25: Kühlkörper
- 26: Masse
- 26.1: DC- & NF-Masse
- 27: Eingangsanpassungsnetzwerk
- 28: Ausgangsanpassungsnetzwerk
- 29: Platine
- 30: Diplexer
- 31: DC- & NF-Versorgungsnetzwerk
- 32: DC- & NF-Versorgung
- 33: HF-Ausgang
- 34: Galvanisch getrennte Gateversorgung
- 35: λ/4-Leitung
- 36: Bond-Drähte

## Patentansprüche

1. Hochfrequenz-Leistungstransistor (1) umfassend:
- einen Transistor (2, 18),
- mindestens einen Kondensator (3, 18),
- ein Gehäuse (12), das den Transistor (2, 18) und den Kondensator (3, 18) zumindest teilweise umgibt,
wobei ein erster Anschluss (4) für einen Hochfrequenz-Eingang und eine Gate-Gleichspannungsversorgung an einem Gatekontakt (5) des Transistors (2, 18) angeschlossen ist,
wobei ein zweiter Anschluss (6) an einem Drainkontakt (7) des Transistors (2, 18) für einen Hochfrequenz-Ausgang und Drain-Gleichspannungsversorgung angeschlossen ist, und
wobei an einem Sourcekontakt (8) des Transistors (2, 18) ein dritter Anschluss (9) und ein vierter Anschluss (10) angeschlossen sind, und
wobei der erste, zweite, dritte und vierte Anschluss (4, 6, 9, 10) alle aus dem Gehäuse (12) herausführen, und
wobei der dritte Anschluss (9) über den Kondensator (3, 18) an den Sourcekontakt (8) angeschlossen ist und der vierte Anschluss (10) über mindestens ein induktives Element (36, 11) an den Sourcekontakt (8) angeschlossen ist, sodass der dritte Anschluss (9) eine Hochfrequenz-Masse bereitstellt und der vierte Anschluss (10) eine potentialfreie Niederfrequenz-Masse und Source-Gleichspannungsversorgung bereitstellt,
wobei das induktive Element (36, 11) einen Bonddraht oder mehrere parallel geschaltete Bonddrähte umfasst, wobei der eine oder die mehreren parallel geschalteten Bonddrähte ein Tiefpassnetzwerk (3.2) bilden, und
wobei eine Länge und Anzahl der Bonddrähte ausgebildet ist eine NF-Bandbreite des Tiefpassnetzwerkes (3.2) einzustellen.

2. Hochfrequenz-Leistungstransistor (1) nach Anspruch 1, wobei der Kondensator (3) ein Einschichtkondensator ist.

3. Hochfrequenz-Leistungstransistor (1) nach einem der vorstehenden Ansprüche, wobei der Hochfrequenz-Leistungstransistor (1) mindestens zwei parallel geschaltete Kondensatoren (3) zwischen dem dritten Anschluss (9) und dem Sourcekontakt (8) umfasst.

4. Hochfrequenz-Leistungstransistor (1) nach einem der vorstehenden Ansprüche, wobei der Transistor (2) und der Kondensator (3) in einem integrierten Schaltkreis (18) kombiniert sind.

5. Hochfrequenz-Leistungstransistor (1) nach Anspruch 4, wobei der integrierte Schaltkreis (18) ein MMIC ist.

6. Hochfrequenz-Leistungstransistor (1) nach einem der vorstehenden Ansprüche, wobei der dritte Anschluss (9) mit mindestens einem elektrisch leitfähigen Flansch (16), vorzugsweise mit zwei gegenüberliegenden elektrisch leitfähigen Flanschen (16) verbunden ist.

7. Hochfrequenz-Leistungstransistor (1) nach einem der vorstehenden Ansprüche, wobei der Hochfrequenz-Leistungstransistor (1) einen fünften Anschluss (17) umfasst, der über mindestens ein induktives Element (36, 11) an den Sourcekontakt (8) angeschlossen ist, sodass der dritte Anschluss (9) eine Hochfrequenz-Masse bereitstellt und der vierte Anschluss (10) und der fünfte Anschluss (17) gemeinsam eine potentialfreie DC- & NF-Masse und Source-Gleichspannungsversorgung bereitstellen.

8. Hochfrequenz-Leistungstransistor (1) nach einem der vorstehenden Ansprüche, wobei zwei gedruckte Leiterplatten (20, 21) auf gegenüberliegenden Seiten des Hochfrequenz-Leistungstransistors (1) angeordnet sind.

9. Hochfrequenz-Leistungstransistor (1) nach Anspruch 8,
wobei der erste Anschluss (4) an eine Leiterbahn (22) der ersten gedruckten Leiterplatte (20) angeschlossen ist, und
wobei der zweite Anschluss (6), der vierte Anschluss (10), sowie gegebenenfalls der fünfte Anschluss (17), an Leiterbahnen (23, 24) der zweiten Leiterplatte (21) angeschlossen sind.

10. Hochfrequenz-Leistungsverstärker nach Anspruch 8 oder 9, wobei der dritte Anschluss (9), vorzugsweise über mindestens einen Flansch (16), an einen Kühlkörper (25) des Hochfrequenz-Leistungsverstärkers angeschlossen ist, der die Systemmasse für den Hochfrequenz-Leistungsverstärker definiert.

## Claims

1. High frequency power transistor (1), comprising:
- a transistor (2, 18),
- at least one capacitor (3, 18),
- a housing (12) at least partially surrounding the transistor (2, 18) and the capacitor (3, 18),
wherein a first terminal (4) for a high frequency input and a gate direct voltage supply is connected to a gate contact (5) of the transistor (2, 18),
wherein a second terminal (6) is connected to a drain contact (7) of the transistor (2, 18) for a high frequency output and drain direct voltage supply, and
wherein a third terminal (9) and a fourth terminal (10) are connected to a source contact (8) of the transistor (2, 18), and
wherein the first, second, third and fourth terminals (4, 6, 9, 10) all lead out of the housing (12), and
wherein the third terminal (9) is connected to the source contact (8) via the capacitor (3, 18) and the fourth terminal (10) is connected to the source contact (8) via at least one inductive element (36, 11), such that the third terminal (9) provides a high frequency ground and the fourth terminal (10) provides a potential-free low frequency ground and source direct voltage supply, wherein
the inductive element (36, 11) comprises one bonding wire or more bonding wires connected in parallel, wherein the one or more bonding wires connected in parallel form a low pass network (3.2), and
wherein a length and number of the bonding wires is designed to set an LF bandwidth of the low-pass network (3.2).

2. High-frequency power transistor (1) according to claim 1, wherein the capacitor (3) is a single-layer capacitor.

3. High-frequency power transistor (1) according to any of the preceding claims, wherein the high-frequency power transistor (1) comprises at least two capacitors (3) connected in parallel between the third terminal (9) and the source contact (8).

4. High-frequency power transistor (1) according to any of the preceding claims, wherein the transistor (2) and the capacitor (3) are combined in an integrated circuit (18).

5. High frequency power transistor (1) according to claim 4, wherein the integrated circuit (18) is an MMIC.

6. High-frequency power transistor (1) according to any one of the preceding claims, wherein the third terminal (9) is connected to at least one electrically conductive flange (16), preferably to two opposing electrically conductive flanges (16).

7. High-frequency power transistor (1) according to any one of the preceding claims, wherein the high-frequency power transistor (1) comprises a fifth terminal (17) connected to the source contact (8) via at least one inductive element (36, 11), such that the third terminal (9) provides a high-frequency ground and the fourth terminal (10) and the fifth terminal (17) jointly provide a potential-free DC & LF ground and source direct voltage supply.

8. High-frequency power transistor (1) according to any one of the preceding claims, wherein two printed circuit boards (20, 21) are arranged on opposite sides of the high-frequency power transistor (1).

9. High frequency power transistor (1) according to claim 8,
wherein the first terminal (4) is connected to a conductive path (22) of the first printed circuit board (20), and
wherein the second terminal (6), the fourth terminal (10), as well as the fifth terminal (17), if any, are connected to conductive tracks (23, 24) of the second printed circuit board (21).

10. High-frequency power amplifier according to claim 8 or 9, wherein the third connector (9) is connected, preferably via at least one flange (16), to a heat sink (25) of the high-frequency power amplifier defining the system mass for the high-frequency power amplifier.

## Revendications

1. Transistor de puissance haute fréquence (1), comprenant
- un transistor (2, 18),
- au moins un condensateur (3, 18),
- un boîtier (12) qui entoure au moins partiellement le transistor (2, 18) et le condensateur (3, 18),
dans lequel une première borne (4) pour une entrée haute fréquence et une alimentation en tension continue de grille est connectée à un contact de grille (5) du transistor (2, 18),
dans lequel une deuxième borne (6) est connectée à un contact de drain (7) du transistor (2, 18) pour une sortie haute fréquence et une alimentation en tension continue de drain, et
une troisième borne (9) et une quatrième borne (10) sont connectées à un contact de source (8) du transistor (2, 18), et
dans lequel les première, deuxième, troisième et quatrième bornes (4, 6, 9, 10) sortent tous du boîtier (12), et
dans lequel la troisième borne (9) est connectée au contact de source (8) par l'intermédiaire du condensateur (3, 18) et la quatrième borne (10) est connectée au contact de source (8) par l'intermédiaire d'au moins un élément inductif (36, 11), de sorte que la troisième borne (9) fournit une masse haute fréquence et la quatrième borne (10) fournit une masse basse fréquence libre de potentiel et une alimentation en tension continue de source, dans lequel
l'élément inductif (36, 11) comprend un fil de liaison ou plusieurs fils de liaison montés en parallèle, l'un ou les plusieurs fils de liaison montés en parallèle formant un réseau passe-bas (3.2) , et
une longueur et un nombre des fils de liaison étant conçus pour régler une largeur de bande BF du réseau passe-bas (3.2).

2. Transistor de puissance haute fréquence (1) selon la revendication 1, dans lequel le condensateur (3) est un condensateur monocouche.

3. Transistor de puissance haute fréquence (1) selon l'une quelconque des revendications précédentes, dans lequel le transistor de puissance haute fréquence (1) comprend au moins deux condensateurs (3) connectés en parallèle entre la troisième borne (9) et le contact de source (8).

4. Transistor de puissance haute fréquence (1) selon l'une quelconque des revendications précédentes, dans lequel le transistor (2) et le condensateur (3) sont combinés dans un circuit intégré (18).

5. Transistor de puissance haute fréquence (1) selon la revendication 4, dans lequel le circuit intégré (18) est un MMIC.

6. Transistor de puissance haute fréquence (1) selon l'une quelconque des revendications précédentes, dans lequel la troisième borne (9) est reliée à au moins une bride électriquement conductrice (16), de préférence à deux brides électriquement conductrices opposées (16).

7. Transistor de puissance haute fréquence (1) selon l'une quelconque des revendications précédentes, dans lequel le transistor de puissance haute fréquence (1) comprend une cinquième borne (17) connectée au contact de source (8) par l'intermédiaire d'au moins un élément inductif (36, 11), de sorte que la troisième borne (9) fournit une masse haute fréquence et que la quatrième borne (10) et la cinquième borne (17) fournissent ensemble une masse DC & BF flottante et une alimentation en tension continue de source.

8. Transistor de puissance haute fréquence (1) selon l'une quelconque des revendications précédentes, dans lequel deux cartes de circuits imprimés (20, 21) sont disposées sur des côtés opposés du transistor de puissance haute fréquence (1).

9. Transistor de puissance haute fréquence (1) selon la revendication 8,
dans lequel la première borne (4) est connectée à une piste conductrice (22) de la première carte de circuit imprimé (20), et
la deuxième borne (6), la quatrième borne (10), ainsi que le cas échéant la cinquième borne (17), étant connectées à des pistes conductrices (23, 24) de la deuxième carte de circuit imprimé (21).

10. Amplificateur de puissance haute fréquence selon la revendication 8 ou 9, dans lequel la troisième borne (9) est connectée, de préférence par l'intermédiaire d'au moins une bride (16), à un dissipateur thermique (25) de l'amplificateur de puissance haute fréquence, qui définit la masse de système pour l'amplificateur de puissance haute fréquence.
